Europäisches Patentamt

**European Patent Office**

Office européen des brevets

(19)

(11) Publication number: **0 203 096**
**B1**

(12) **EUROPEAN PATENT SPECIFICATION**

(45) Date of publication of patent specification: **10.01.90**

(21) Application number: **85905357.1**

(22) Date of filing: **11.10.85**

(86) International application number:
**PCT/US85/02005**

(87) International publication number:
**WO 86/02793 09.05.86 Gazette 86/10**

(51) Int. Cl.⁵: **H 03 K 21/40, H 03 K 23/44, H 03 K 5/15**

(54) **SELF-CORRECTING FREQUENCY DIVIDERS.**

(30) Priority: **29.10.84 US 665986**

(43) Date of publication of application:
**03.12.86 Bulletin 86/49**

(45) Publication of the grant of the patent:
**10.01.90 Bulletin 90/02**

(84) Designated Contracting States:
**BE DE FR GB IT NL**

(56) References cited:
**US-A-3 609 391**
**US-A-3 896 388**

**Patents Abstracts of Japan, volume 5, no.23(E-45695), 12 February 1981 & JP, A, 55149537
Electrical Design News, volume 14, no. 10, May 1969, Denver Co., (US) SEPE: "Ring around-the-counter", pages 80-81,**

**IBM Technical Disclosure Bulletin, volume 15, no. 2, July 1972, New York, (US) Alcantar et al.:"Shift register counter", pages 613-614**

(73) Proprietor: **AMERICAN TELEPHONE AND TELEGRAPH COMPANY**
**550 Madison Avenue**
**New York, NY 10022 (US)**

(72) Inventor: **BAYRUNS, Robert, Joseph**
**29 Whitney Drive**
**Middlesex, NJ 08846 (US)**

(74) Representative: **Buckley, Christopher Simon Thirsk et al**
**Western Electric Company Limited 5 Mornington Road**
**Woodford Green Essex IG8 OTU (GB)**

Courier Press, Leamington Spa, England.

EP 0 203 096 B1

**Description**

This invention relates to self-correcting frequency divider circuits. Such circuits which are self-correcting (self-initializing) and thus do not require initialization or reset are useful, for example, for supplying the control timing for either the multiplexing or the demultiplexing of data streams.

Present-day and presently proposed fiber optics systems transmit information in the form of binary data streams from a sender through an optical fiber transmission channel to a receiver at data rates or frequencies of the order of gigabits ($10^9$ bits) per second as projected by circuit simulation techniques. A data stream is a sequence of pulses, each of the pulses being developed by the sender within a separate preassigned time slot, and the amplitude or height of each such pulse typically representing a separate piece of information—typically a "bit" (binary digit) of data, in binary logic. Each such bit accordingly is valid only within the separate corresponding time slot. For orderly synchronous transmission, each such time slot has a duration equal to a period or cycle of a clock control timer (typically a clock pulse sequence).

In such systems, frequency divider circuits (i.e., circuits for reducing by an integral factor the frequency of electrical clock pulses) are particularly useful for supplying electrical timing control required for multiplexing (or demultiplexing) the data streams supplied to (or by) the optical fiber. By "multiplexing" is typically meant, for example, the process of delivering into a single common transmission channel during separate time slots the data coming from a multiplicity, say $n$, of separate individual channels; so that, for example, in binary digital transmission the single common channel propagates in sequence, say one piece or bit of data from the first individual channel, followed by one bit from the second individual channel, . . ., followed by one bit from the n'th individual channel, followed by one new bit from the first individual channel, etc. (i.e., repeating the cycle of one bit in succession from each individual channel). The result is thus n-fold multiplexing of data into the common channel from the individual channels. Such multiplexing is known as "time division multiplexing", and can also be used in connection with sampled analog transmission, as known in the art (but will not be discussed further, only for the sake of simplicity). By "demultiplexing" is meant the opposite process, that is, of sequentially delivering the data propagating in the common channel into the multiplicity of $n$ channels; so that, for example, the first bit in the common channel is delivered to the first channel, the second bit is delivered to the second channel, . . ., the n'th bit is delivered to the n'th channel, the (n+1)'th bit is delivered to the first channel, etc. The result here is thus n-fold demultiplexing of data from the common channel into the individual channels. Typically, multiplexing is performed at the sender, while demultiplexing is performed at the receiver, and the data propagates in the common channel from sender to receiver.

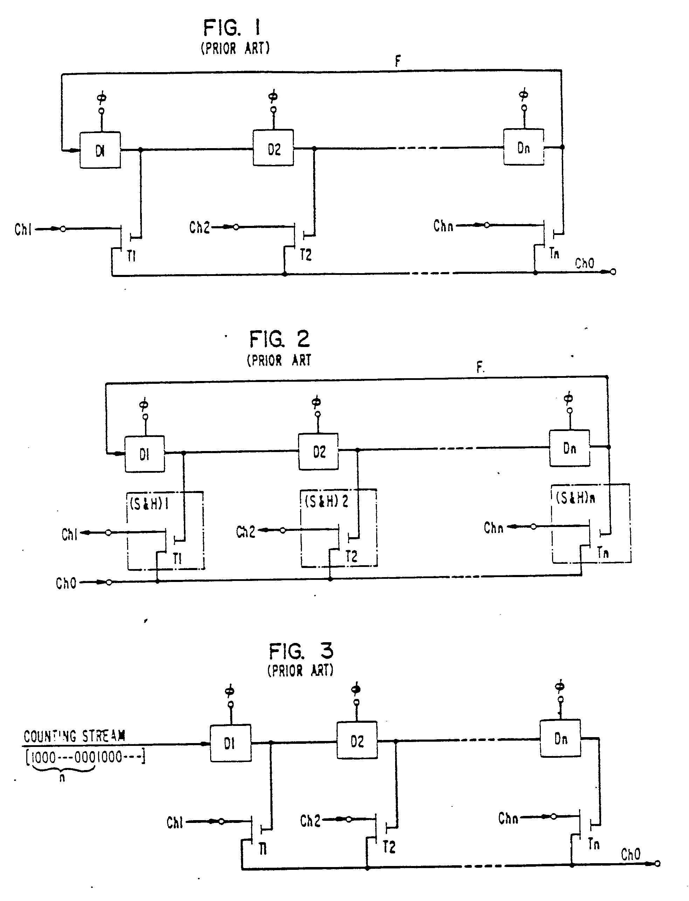

The invention will be described with reference to the accompanying drawings, in which: Fig. 1 shows a known data multiplexing scheme;

Fig. 2 shows a known data demultiplexing scheme;

Fig. 3 shows another known data multiplexing scheme;

Fig. 4 shows a known self-correcting frequency divider;

Fig. 5 shows a self-correcting frequency divider embodying the invention used in a multiplexing circuit; and

Figs. 6—9 show portions of self-correcting frequency dividers embodying the invention.

All transistors shown are typically n-channel MOS (*metal oxide semiconductor*) transistors, i.e. NMOS technology. Each inverter symbol represents a conventional NMOS inverter formed by an enhancement mode transistor (driver) connected in series with a depletion mode transistor (load) between ground and a power line ($V_{DD}$).

Fig. 1 shows a known circuit arrangement for multiplexing at a receiver, for example, a multiplicity $n$ of different data bit streams—each stream propagating in a separate one of a multiplicity $n$ of separate individual incoming channels Ch1, Ch2, . . . Chn—into a single common outgoing channel Ch0. Assume for definiteness that the bit rate in each of the individual incoming channels Ch1, Ch2, . . . Chn is given by f/n bits per second, and hence that the bit rate in the common channel Ch0 is $f$ bits per second. To accomplish the desired multiplexing, each stage of an n-stage serial shift register (i.e., $n$ successive clocked latches which impart delays D1, D2, . . . Dn, respectively, to data circulating in the register) has its timing for reception and delivery of data controlled by the same clock pulse sequence φ. Each stage imparts the same delay D=D1=D2= . . . Dn to the data circulating through the register synchronously with the flow of data in the channel Ch0, i.e., such that D=1/f. The register is arranged and operated as a "ring counter", that is, with the n'th (last) stage of the register connected for feeding back its output as input to the first stage of the register, each stage being initialized as described below. Typically, each stage of the serial register is a master-slave latch controlled by a two-phase clock control timing pulse sequence φ having a period T=1/f, for controlling the timing of the reception and delivery of new data to and from each stage. Thus, the delay D of each stage is equal to the period T of the sequence φ, as known in the art. During operation, the register must be properly initialized, i.e., by setting one and only one of the stages with a one bit and resetting every other stage with a zero bit. As time progresses during operation, the one bit moves from its original position through the shift register to the last (n'th) stage, then (through a feedback line F) to the first stage, and then again through the register to the last stage, etc., whereby during any single clock period (cycle) every stage of the register contains a zero bit except for a single stage that contains the one bit. By the time the single one bit thus circulates through the register back to its original position, say the i'th stage, the i'th channel Chi presents its next new bit of data. Each of an array of *n* separate input transmission gates in the form of pass transistors T1, T2, . . . Tn (each typically an enhancement mode MOS transistor) is connected for sensing at its input control (gate) terminal the bit which is instantaneously the content and hence output of a separate one of the shift register stages. Thereby, the shift register supplies control timing for turning on and off each transmission gate, whereby each transmisstion gate is turned on by a one bit and off by a zero bit supplied by and delivered from the corresponding shift register stage, and thus each transmission gate delivers the instantaneous data bit in the corresponding channel Ch1 . . . Chn to the common channel Ch0 in response to the one bit. Thus, since only a single one bit circulates in the entire register, only one transmission gate can be on at a time, so that only one data bit is delivered to the common channel Ch0 at a time, that is, a data bit from the individual one of the channels Ch1, Ch2, . . . Chn which is connected to that one of the input pass transistors T1, T2, . . Tn, which is on.

Accordingly, as the single one bit successively shifts from one stage to the next through the *n* stages of the shift register, the pass transistors T1, T2, . . . Tn are successively turned on, one after the other, whereby the data coming in on the channels Ch1, CH2, . . . Chn is transmitted (multiplexed) onto the common outgoing channel CH0 in a succession of a bit of data from one channel after another, as is desired in the case of multiplexing the channels Ch1, Ch2, . . . Chn onto the channel Ch0. The multiplexer arrangement shown in Fig. 1 is also known as a "parallel-to-serial" converter, since it converts *n* parallel input data streams propagating from channels Ch1, Ch2, . . . Chn into a single stream propagating in the common channel Ch0. In this common channel, one bit of data from each of the *n* streams thus flow serially after the other. Note that the resulting data stream flowing in the channel Ch0 automatically has a bit rate equal to *f*, that is, a bit rate equal to *n* times the bit rate (f/n) of each of the data streams flowing in the individual channels Ch1, Ch2, . . . Chn. Note also that the frequency at which the single one bit reappears in any given stage of the shift register is equal to f/n=f÷n, and thus the n-stage shift register connected and operated as a ring counter performs a frequency division of the clock pulse sequence φ, the frequency of sequence φ being equal to 1/T=f.

After transmitting the multiplexed signal in the transmission channel Ch0 from sender to receiver, demultiplexing (serial-to-parallel conversion) of the incoming multiplexed channel Ch0 at the receiver into (demultiplexed) channels Ch1, Ch2, . . . Chn can be performed (Fig. 2) by delivering the data from the multiplexed incoming channel Ch0 through a multiplicity *n* of separate Sample and Hold circuits (S&H)1, (S&H)2, . . . (S&H)n. Each of these Sample and Hold circuits has a separate sampling transmission gate T1, T2, . . . Tn which is controlled by a separate bit from an n-bit serial shift register to which the counting stream is delivered as input. The Sample function of each Sample and Hold circuit is activated by a one bit; the Hold function, by a zero bit. Input pass transistors T1, T2, . . . Tn of the Sample and Hold circuits (S&H)1, (S&H)2, . . . (S&H)n in the demultiplexing scheme shown in Fig. 2 are controlled as to their respective timing (on versus off) by a serial shift register in the same manner as the input pass transistors T1, T2, . . . Tn in the multiplexing circuit shown in Fig. 1, that is, by a (properly initialized) ring counter of *n* stages, whereby the channel Ch0 is demultiplexed (serial-to-parallel) onto the individual channels Ch1, Ch2, . . . Chn.

Note that the use in the n-fold demultiplexer of pass transistors clocked by an n-bit counting stream is preferred over the use of edge-triggered flip-flops clocked by a square wave propagating along a delay line because of the undesirable added gate delays in the response of the flip-flops ("set-up time" delay for edge-triggered latches).

Note also that each of the n-stage shift registers connected and operated as ring counters in Figs. 1 and 2 supplies to each stage of each register a periodic data stream, each period having a total of *n* bits characterized by a single one bit and (n−1) zero bits. The time between arrivals at any given stage of successive one bits (in consecutive periods) is thus nT, and the frequency of such arrivals of successive one bits is thus f/n=f÷n. Accordingly, the ring counters operate as frequency dividers. In particular, each n-stage register as a ring counter supplies a data stream of bits at the input end of the respective first stage (same as output end of last stage) thereof which is a periodic sequence having a period of *n* bits in length, each period having a time duration equal to nT and being composed of a single one bit followed by a successiong of (n−1) zero bits. Thus, as shown in Fig. 3, equivalent operation can be achieved without the feedback; the feedback can thus be removed—i.e., the output of the last (n'th) stage of the shift register is not fed back to the first stage but is delivered only to the gate terminal of the n'th transmission gate Tn—and, instead of the feedback, the input stage of the n-stage shift register can be supplied with an input periodic stream of bits also having a period of *n* bits, in length (nT in time), each such period also being composed of a single one bit followed by a succession of (n−1) zero bits. This periodic data stream can thus bs represented symbolically as the stream

$$[1000 . . . 0001000 . . . 0001000 . . . ]$$

Here, each of the triple dots represents a sequence of consecutive zeros in sufficient number (n−7) to make the distance between successive one bits equal to the period $n$. Thus, this particular stream also has a period between successive one bits equal to $n$ measured in bits (nT measured in time). Such a periodic bit stream can be viewed (upon Fourier analysis, for example) as a frequency divided sequence having a repetition rate or frequency equal to 1/nT ("divide by $n$"), which can also be denoted as a periodic counting-bit stream of periodicity $n$ ("modulo $n$") or simply as an n-bit counting stream. The n-bit counting stream (of periodicity $n$) is thus equivalent to a frequency division by $n$. In general, such an n-bit counting stream can be any periodic binary (i.e., two-level) digital signal, each period having a plurality of time slots $n$ in number, the signal carried by one of such time slots in each period being of one level, and the signal carried by the other (n−1) slots in each period being of the other level. Thus, in addition to the n-bit counting stream

$$[1000 \ldots 0001000 \ldots 0001000 \ldots .],$$

where each period of $n$ bits in length consists of a single one (high level) bit followed by (n−1) zero (low level) bits, we have (by inversion) the inverted n-bit counting stream

$$[0111 \ldots 1110111 \ldots 1110111 \ldots],$$

where each period of $n$ bits consists of a single zero bit followed by (n−1) one bits. Both such periodic streams will be referred to simply as counting streams. In either case, however, it is important for the counting stream to be synchronous with the clock ɸ—that is, for successive bits in the counting stream to be valid at the shift register during successive time slots corresponding to (portions of) successive periods of the clock ɸ when the register can accept successive new data. Thus, the process of multiplexing (or demultiplexing) for $n$ channels requires a counting stream of periodicity $n$ as input to an n-stage shift register each of whose stages controls the timing (on versus off) of a separate transmission gate or switching element, such as a transistor (or a Sample and Hold Circuit), connected between a common channel and a separate individual channel.

A problem with the n-stage shift registers arranged with feedbacks as a ring counter (Figs. 1—2) is that—in addition to the requirement for initializing the register by setting a single stage with a one bit and resetting every other stage with a zero bit—the register should be repeatedly re-initialized, owing to the random errors or false bits, which can arise and thereafter continually circulate in the ring counter during operation. That is, whenever an error occurs in the register, the need arises to correct the error, as by again setting (with a one bit) a single stage and resetting (with a zero bit) every other stage; otherwise, the error would undesirably persist. Thus, after a false bit occurs in a ring counter but before reinitializing, the counter will supply false control signals to the input pass transistors T1, T2, ... Tn, whereby false multiplexing (or demultiplexing) undesirably occurs. Moreover, detection of the occurrence of false bits in, and re-initialization of, the counter would require undesirable extra circuitry and hence added cost.

Likewise, in a ring counter having an inverter in the feedback loop—called a "switchtail" or Johnson counter—during proper operation in the $n$ shift registers in the counter should attain (in sequence) only $2^n$ different states out of the possible 2n different states attainable by $n$ shift registers, a state being defined as a specific configuration of 0's and 1's in the registers. During operation, therefore, 2n states are "proper", whereas the remaining (2n—$2^n$) states are "improper". If such a counter were initialized or were otherwise put in any one of the ($2^n$—2n) improper states during operation, the counter would never get back (unless a felicitous further error occurs) into any one of the 2n proper states. Thus, if through error during operation such a counter attains any of the ($2^n$—2n) improper states, such error must be detected and the counter must be re-initialized—all of which would require undesirable extra circuitry.

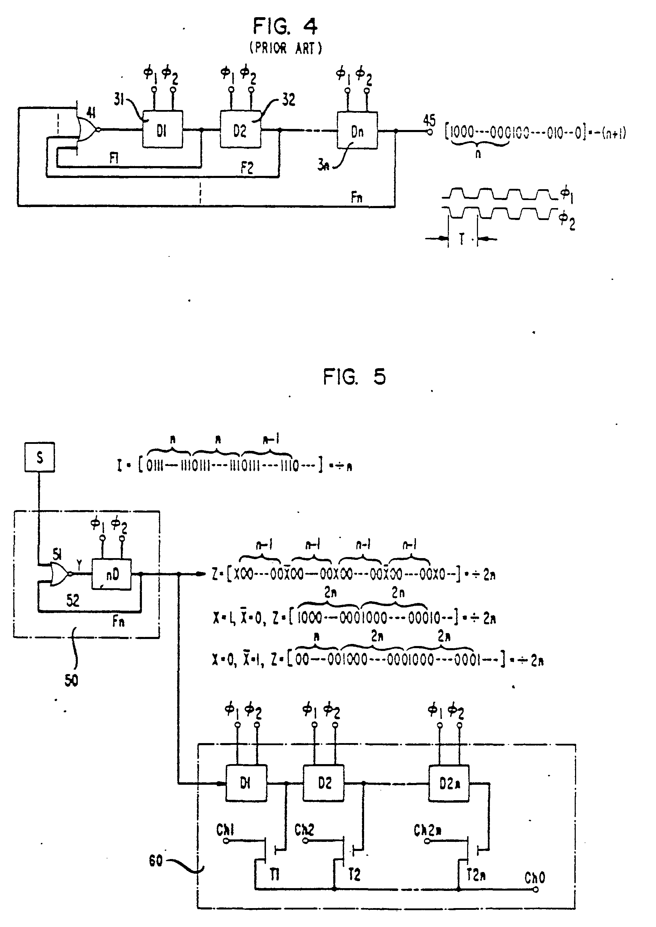

In prior art, a frequency dividing circuit which is self-initializing (self-correcting) to avoid the need for such extra circuitry has been furnished by the arrangement shown in Fig. 4. Here, an n-stage shift register is formed by a successsion of shift register stages formed by a succession of master-slave (ɸ₁ɸ₂) clocked latches 31, 32, 33, 34, ... 3n, each controlled by first and second phase clock pulse sequences ɸ₁ and ɸ₂. Each such latch thereby forms a separate stage for imposing an (equal) associated delay D1=D2= ...=Dn(=D) upon the signal propogating from left to right, the output of each such stage being fed back through a separate feedback line, F1, F2, F3, F4, ... Fn, as input to an n-input NOR gate 41. Thereby, the output—divide by (n+1) or ÷(n+1)—of the arrangement is delivered to an output terminal 45 in the form of a counting stream of periodicity (n+1)—i.e., a periodic bit stream in which each period of bits consists of a single one bit followed by $n$ zero bits. Note that the latches in all stages again are all clocked by the same master-slave control timing sequence (ɸ₁ɸ₂) having a periodicity again equal to T, as known in the art, so that the successive time slots of successive bits in the bit stream are also spaced in time by the period T of the sequence (ɸ₁ɸ₂). The NOR gate 41 operates to deliver a zero bit to the first register stage 31 during every cycle of the clock unless and until all inputs to the NOR gate 41 are zero—i.e., unless and until every stage stores a zero bit. Thus, when and only when every stage finally stores a zero, the NOR gate 41 finally delivers a one bit. In this way, the output terminal 45 then delivers the desired output sequence in the form of a succession of $n$ zero bits followed by a single one bit, and thereafter likewise another succession of $n$

zero bits followed by a single one bit, etc. Note that if at any time an error in the form of a spurious one (or zero) bit is developed in any stage of the register, nevertheless, after at most $n$ cycles of the clock the error will have been corrected by the NOR gate 41 and the desired output sequence will have resumed. A multiple input NOR gate, i.e., the n-input NOR gate 41, however, requires in NMOS technology, for example, an array of $n$ similar N-channel transistors mutually connected in parallel, and such an array for $n$ greater than 2 or 3 causes undesirably slow operation due to the undesirably high parasitic capacitance and hence parasitic RC delay produced by the required $n$ similar transistors in parallel (i.e., about $n$ times the delay of each transistor). In PMOS and CMOS technologies, the multiple input NOR gate requires a chain of $n$ similar P-channel transistors connected in series, and such an array for $n$ greater than 2 or 3 also causes slow operation due to the undesirably high RC parasitics in such a chain.

U.S. Patent No. 3,609,391 published on 28 September 1971 discloses a self-correcting frequency divider circuit. However, in addition to requiring (slower) triple-input NOR gates, the circuit also requires AND gates that fan out, that is, AND gates each of whose outputs is required to drive a plurality of (to wit, four) shift register stages. Thus, means for amplifying (boosting) each of the outputs of the AND gates is needed, whereby undesirably further slower operation results. Therefore, it would be desirable to have a self-correcting frequency divider circuit that avoids these shortcomings of the prior art.

According to this invention there is provided a self-correcting frequency divider circuit for converting an input n-bit counting stream having a periodicity equal to nT into an output 2n-bit counting stream having a periodicity equal to 2nT, where $n$ is an integer greater than unity, and where each periodic counting stream has a plurality of time slots equal to the number of bits in any one period, the signal carried by a single one of the time slots in each period being of one binary level, and the signal carried by the or each other time slot in each period being of the other level, the circuit including a two-input NOR gate having one of its two input terminals connected for receiving the input n-bit counting stream, and a delay device having its input terminal directly connected to the output terminal of the NOR gate and its output terminal directly connected both to the other input terminal of the NOR gate and to the frequency divider circuit output terminal, whereby the circuit output terminal delivers the output 2n-bit counting stream in response to the input n-bit counting stream.

The 2n-bit counting stream can then be delivered to a utilization means for using the control timing corresponding to the 2n-bit stream, such as 2n-fold multiplexing or demultiplexing circuit. By cascading first and second successive frequency dividing circuits (the output of the first being an input of the second)—the first for converting an n-bit to a 2n-bit counting stream, the second for converting a 2n-bit to a 4n-bit counting stream—an n-bit counting stream of period T can be converted into a 4n-bit counting stream of period 4T.

As used herein, the term "NOR gate" in the context of being directly connected to a delay device should be understood to include functional logical equivalents—such as an OR gate in the context of being directly connected to an inverting delay device, i.e., a delay device that has the property of inverting the data stream flowing through it.

In a specific embodiment, the delay device is formed by an n-stage shift register, each stage being a pair of transistors connected in series and timed in a master-slave relationship by means of a two-phase clock pulse sequence having the same periodicity as that of the duration of each time slot of the input n-bit counting stream. Thus, the timing of each stage of the shift register is synchronous with the timing of the n-bit counting stream. The resulting output of the delay device—i.e., the resulting output of the frequency dividers—is connected as input to a 2n-stage serial shift register which, in turn, is clocked synchronously with the counting stream, the output of each stage being connected for control timing of a corresponding one of each transmission gate in an array of 2n transmission gates arranged for 2n-fold multiplexing or demultiplexing of data channels. Moreover, there are at most two inverter delays between any two successive pass transistors along the data path of the shift register, in order to enable high speed of operation, that is, to enable a bit rate of about 2 gigabits per second as projected by circuit simulation techniques.

Fig. 5 shows a self-correcting frequency divider 50 which converts an input n-bit counting stream I supplied by a source S into an output 2n-bit counting stream Z. This stream Z, in turn, controls a multiplexer 60 comprising a 2n-stage serial shift register (i.e., having 2n master slave stages denoted by D1, D2, ... D2(n), each stage timed by the same clock control timing sequence φ which is synchronous with the timing of the counting stream I, whereby data in the shift register are shifted from every stage (except for the last) to the next succeeding stage during each clock period T of the sequence φ, each such clock period being synchronous with a corresponding time slot of the counting stream I during each of which a different corresponding bit of the stream I is valid at the register. Thus, each stage delays the counting stream I by an amount of time $D=T=1/f$, where $f$ is the bit rate of the counting stream I.

The frequency divider 50 includes a two-input NOR gate 51 and a delay device 52. The NOR gate is connected for delivering its output data Y as input data to the delay device. The delay device 52 is constructed so as to delay the data propagating through it by an amount of time equal to nD, that is, $n$ times the period $T=1/f$ associated with the duration of one time slot of the counting stream I.

One of the input terminals of the NOR gate 51 is connected for receiving the counting stream I, and the other of the input terminals of the NOR gate 51 is connected for receiving as feedback Fn the output Z of the delay device 52. The output Z is a 2n-bit counting stream.

The multiplexer *60* is constructed and operates in the same way as in prior art (Fig. 3), and has a 2n-stage serial shift register which is connected for receiving the 2n-bit counting stream Z, whereby the multiplexer *60* can perform 2n-fold multiplexing. The output Z can also be delivered as a 2n-bit counting stream to another frequency divider (not shown) similar to the divider 50 except that instead of a delay device 52 with a delay of nD it now has a delay device with a delay of 2nD.

During operation, the NOR gate 51 delivers a zero bit during all clock periods except for every n'th period when the counting stream I delivers a zero bit to the NOR gate, i.e., when I=0. Thus, depending upon whether the (then indeterminate) output Z (and hence also the feedback Fn which is always equal to Z) is then a zero (Z=0) or a one (Z=1), the output Y of the NOR gate during every such n'th period will then be a one (Y=1) or a zero (Y=0), i.e., also indeterminate (denoted by X). On the other hand, every such n'th period, the logic value of the output Z=Fn is inverted by the NOR gate 51, whereby the logic values of the indeterminate bits in the output Z alternate (between X and its inverse $\overline{X}$). Thus, regardless of whether the value of X is zero or one, the output Z will be a 2n-bit counting stream, as shown in Fig. 5. This 2n-bit counting stream Z can then be used to control the timing of the 2n-fold multiplexer *60* in a similar manner as the n-bit counting to control the timing of the n-fold multiplexer previously described (Fig. 3). It should be understood, of course, that the 2n-bit counting stream Z can also be used to control the timing of a 2n-fold demultiplexer, similarly as previously described in connection with Fig. 2.

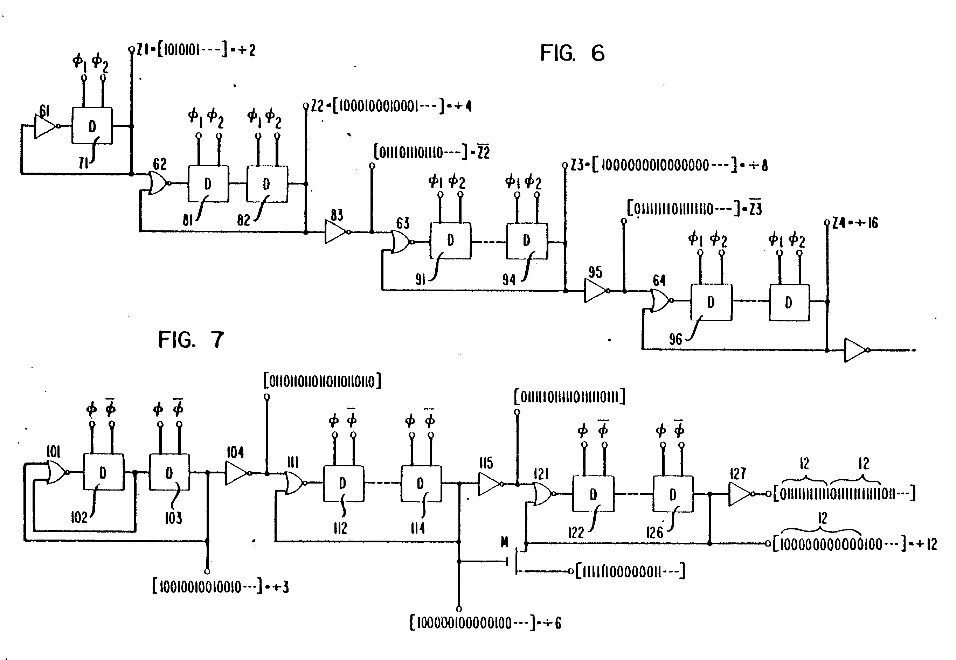

The output Z, in the form of a 2n-bit counting stream, is thus equivalent to a divide by 2n(÷2), that is, a one bit occurs in Z only once during every 2n time slots. Fig. 6 shows a frequency divider for dividing by 2, 4, 8, etc. Here each box labelled D is a synchronous delay element, such as a master-slave shift register stage whose timing is controlled by a clock pulse sequence φ and its inverste $\overline{\varphi}$. Thus, the delay imposed upon the flow of data through each delay element D is equal to the period of the clock sequence φ. In particular, a delay element 71 is connected for receiving as its input data the output of a first inverter 61 which, in turn, is connected for receiving as its input (feedback) data the output Z1 from the synchronous delay element 71. An input terminal of a first NOR gate 62 is connected for receiving the output Z1 from the delay element 71. An output terminal of the NOR gate 62 is connected to deliver its output to a two-stage shift register formed by a pair of serially-connected synchronous delay elements 81 and 82. In turn, the output Z2 of this two-stage shift register is delivered as feedback to another input terminal of the NOR gate 62 and as input to a second inverter 83.

Similarly, the output terminal of the inverter 83 is connected to an input terminal of a second NOR gate 63 which is connected in a feedback arrangement with a four-stage shift register formed by four serially connected synchronous delay elements 91, 92, 93 and 94. The output Z3 of this four-stage shift register is delivered through a third inverter 95 to a third NOR gate 64 which is connected in a feedback arrangement with an eight-stage shift register formed by 96, etc. (not shown in detail).

During operation, due to feedback to the inverter 61 from the delay element 71, the output Z1 is a 2-bit counting stream, as known in the art. Moreover, the output Z2 is a four-bit counting stream, by analogy to Fig. 2 with n=2. Similarly, the output Z3 is an eight-bit counting stream, and the output Z4 is a sixteen-bit counting stream. Thus, by cascading (in series) the frequency dividers formed by successive shift registers (of increasing numbers of stages), frequency division by $2^i$, i=any integer, can be achieved (the number of shift register stages in the last cascade being equal to $2^{(i-1)}$. Notice that the output $\overline{Z2}$ of the inverter 83 is a four-bit counting stream, complementary to Z2; and that the output $\overline{Z3}$ of the inverter 95 is an eight-bit counting stream, complementary to Z3.

Fig. 7 shows another frequency divider (in a cascade arrangement) for dividing by 3, 6, 12, etc., i.e. by $3 \times 2^i$. A first cascade stage comprises a pair of synchronous delay elements 102 and 103 in a double feedback arrangement with a two-input NOR gate 101, whereby the operation divide by 3 is achieved. A second cascade stage comprises three serially connected synchronous delay elements 112, 113 and 114 to form a three-stage shift register. The output (÷6) of this three-stage register is connected in a feedback arrangement to one input terminal of the a two-input NOR gate 111. The output of the first cascade is a three-bit counting stream (÷3). This output is also fed through an inverter 104 to the other input terminal of the NOR gate 111. Similarly, a third cascade stage comprises a six-stage shift register, formed by six serially connected synchronous delay elements 122—126, the output (÷12) of which is connected as feedback to an input terminal of a NOR gate 121 (as well as to an inverter 127 to obtain the complementary ÷12 counting stream). The other input terminal of the NOR gate 121 is connected to the output terminal of the inverter 115 in order to receive a six-bit counting stream from the inverter. Thus frequency division in the form of any counting stream of the form $\div 3 \times 2^i$ (with *i* an integer greater than 2) can be obtained by cascading such shift registers further with the number of stages in the last register being equal to $3 \times 2^{i-1}$. Moreover, a square-wave sequence of periodicity equal to 12 bits can be obtained at the drain terminal of a MOS enhancement mode transistor M which has its gate terminal connected to the six-bit counting stream ($\div 6$) and has its source terminal connected to the twelve-bit counting stream ($\div 12$).

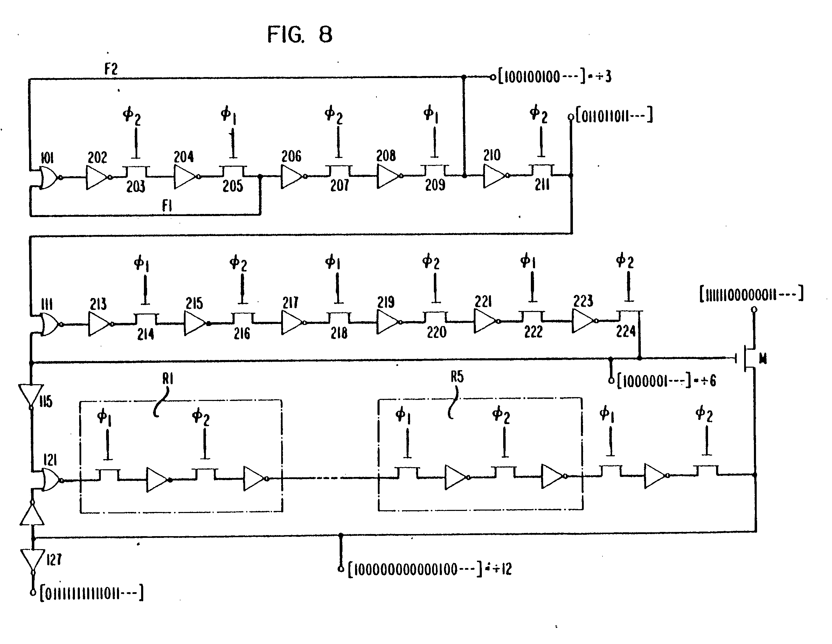

Fig. 8 shows the frequency divider shown in Fig. 7 at the transistor level of the shift registers. Elements in Fig. 8 which are the same as in Fig. 7 are given the same reference numerals. Here (Fig. 8) $\phi_1$ and $\phi_2$ are mutually nonoverlapping two-phase clock pulse sequences, and are ordinarily the same as $\phi$ and $\bar{\phi}$, respectively, except for possible safety margins. Each pair of clocked ($\phi_1 \phi_2$) pass transistors together with their two serially connected adjacent inverters forms a separate one of master-slave shift register stages R1, ... R5. On the other hand, the first cascade stage comprises the NOR gate 101, inverters 202, 204, 206, 208, and clocked pass transistors 203, 205, 207, 209. The output ($\div 3$) thereof is fed through inverter 210 and an extra-clocked pass transistor 211 to the NOR gate 111 of the second cascade stage. Each pass transistor together with an inverter forms a separate dynamic shift register stage, as known in the art. The extra clocked pass transistor 211 is inserted, as shown, between the inverter 210 and the NOR gate 111 in order to avoid the flow of data through three inverters, and hence to avoid a delay of three inverters in succession (counting NOR gate also as an inverter delay). Thus (except for the added clocked pass transistor 211), Fig. 8 is a straightforward dynamic shift register implementation of Fig. 7.

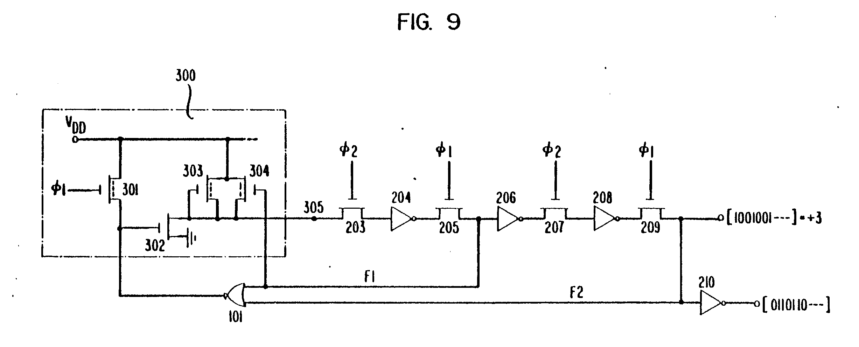

Fig. 9 shows a modified form of the first cascade stage of the frequency divider shown in Fig. 8 at the transistor level of the shift registers. Elements that are the same are denoted by the same reference numerals. Again as in Fig. 8, each shift register stage in Fig. 9 is a dynamic master-slave shift register stage formed by a clocked pass transistor in series with an inverter. Between the NOR gate 101 and the clocked pass transistor 203 is connected an anticipatory inverter 300, that is, an inverter which anticipates a (low voltage level) zero bit for the purpose of faster speed of operation as explained below. This inverter 300 has an output terminal 305 and comprises an enhancement mode transistor 302 and depletion mode transistors 301, 303, and 304. The transistor 301 has its source-drain path connected between the output terminal of the NOR gate 101 and a power line $V_{DD}$ (typically +5 volts), and its gate terminal connected to the first clock pulse sequence $\phi_1$. The transistor 302 has one end of its source-drain path connected to ground and the other end through the parallel-connected source-drain paths of transistors 303 and 304 to $V_{DD}$. The gate terminal of transistor 302 is connected to the output terminal of the NOR gate 101; the gate terminal of transistor 303, to its source terminal; and the gate terminal of transistor 304 to the input terminal of the inverter 206.

The purpose of the anticipatory inverter 300 in Fig. 9 is to perform the same inverter-like function as does the (conventional) inverter 202 in Fig. 8 except that the inverter 300 contains added transistors 301 and 304 so that it can operate faster than a conventional inverter (enhancement mode transistor driver in series with depletion mode transistor load), as discussed below. In that discussion it should be remembered that the delay of a transistor acting as a transmission gate or pass transistor is significantly less than an inverter delay.

In Fig. 9, the transistors 302 and 303 are connected and operate together as a conventional inverter. The transistors 301 and 304 are added for faster response time of the inverter and hence for faster speed of operation. These transistors 301 and 304 preferably are zero threshold enhancement, but depletion mode transistors can also be used to avoid the neeed for extra processing steps. In particular, the added clocked transistor 301 helps to speed up the response of the inverter 300 when the feedback F2 goes from a high to a low voltage level. Specifically, this transistor 301 pulls up the voltage at the output terminal of the NOR gate 101 immediately at the commencement of the first phase of each clock cycle, i.e., when the first phase $\phi_1$ goes high. At most, during (proper) operation, only a single one bit (high voltage level) is present at any time in the feedbacks F1 and F2, and the feedback F1 is in the form of the sequence [010010 . . .], while the feedback F2 is in the form of the sequence [001001 . . .]. Thus, when the feedback F2 goes from a high voltage level to a low level (i.e. at a time when the feedback F1 remains low), and hence when the NOR gate 101 should pull up the voltage of its own output terminal, then the clocked transistor 301 starts this pull up immediately upon the commencement of the high phase of the first clock $\phi_1$ and hence the transistor driver 302 starts to turn on and pull down the output terminal 305 of the anticipatory inverter 300, rather than requiring the NOR gate 101 itself to start to pull up the voltage at its output terminal, i.e. rather than waiting for a gate delay time interval of the NOR gate. Notice that, since the feedback F1 remains low during the excursion when F2 goes from high to low, the transistor 304 remains in a relatively low conducting condition throughout the excursion. On the other hand, the added transistor 304 serves to aid in a fast pull up of the output terminal 305 when the feedback F1 goes from a low to a high level—i.e. at a time when the feedback F2 remains low—and hence when the output terminal of the NOR gate 101 should go from high to low and the output terminal 305 of the inverter 300 should go from low to high. Specifically, at the commencement of the first phase of the clock gate when $\phi_1$ goes high, the feedback F1 rather quickly goes high (as limited response time only by the relatively small delay of the transistor 205 acting as a pass transistor) and strongly turns on the added transistor 304, whereby the output terminal 305 receives an early boost in being pulled up without waiting for the response of the NOR gate 101, the delay in the (inverting) NOR gate being significantly greater than the delay in a pass transistor-like transistor 205.

Various modifications will occur to those skilled in the art. For example, instead of dynamic shift register stages which are formed by master-slave dynamic latches, static latches (flip-flops) as known in the art can be used.

**Claims**

1. A self-correcting frequency divider circuit (50) for converting an input n-bit counting stream (I) having a periodicity equal to nT into an output 2n-bit counting stream (Z) having a periodicity equal to 2nT, where $n$ is an integer greater than unity, and where each periodic counting stream has a plurality of time slots equal to the number of bits in any one period, the signal carried by a single one of the time slots in each period being of one binary level, and the signal carried by the or each other time slot in each period being of the other level, the circuit including a two-input NOR gate (51) having one of its two input terminals connected for receiving the input n-bit counting stream, and a delay device (52) having its input terminal directly connected to the output terminal of the NOR gate and its output terminal directly connected both to the other input terminal of the NOR gate and to the frequency divider circuit output terminal, whereby the circuit output terminal delivers the output 2n-bit counting stream in response to the input n-bit counting stream.

2. A circuit as claimed in claim 1 wherein the delay device (52) has $n$ serially connected stages each arranged for delaying the counting stream by an amount of time equal to T.

3. A self-correcting frequency divider circuit wherein the circuit serves to convert an input n-bit counting stream into a 4n-bit counting stream and includes first and second cascaded frequency dividing circuits, the first circuit being a circuit as claimed in claim 1 or 2 and the second circuit being a circuit as claimed in claim 1 or 2 except that $n$ is twice as large in the second circuit as in the first circuit.

4. A circuit as claimed in claim 1 wherein the delay device is a serial shift register having $n$ stages, the n-bit counting stream being a periodic sequence of a single one bit followed by $(n-1)$ zero bits, each bit being valid during a separate time slot of duration T, and each stage of the register is connected for being clocked synchronously with the time slots.

5. A circuit as claimed in claim 4 wherein the n-bit counting stream is a three-bit counting stream produced by a counter having first (300, 203—205) and second (206—209) serially connected dynamic master-slave shift register stages, an output terminal of each of the first and second stages being respectively connected to first and second input terminals of another NOR gate (101), and the output terminal of the NOR gate being connected to an input terminal of an anticipatory inverter (300) including a clocked first transistor (301) whose source-drain path is connected between a power line ($V_{DD}$) and the input terminal of the anticipatory inverter, a second transistor (302) whose gate terminal is connected to the output terminal of the NOR gate (101) and whose source terminal is connected to a reference voltage terminal, a third transistor (303) whose source terminal is connected to its gate terminal and to the output terminal (305) of the anticipatory inverter, and whose drain terminal is connected to the power line ($V_{DD}$), and a fourth transistor (304) whose gate terminal is connected to the output terminal of the first stage and whose source-drain path is connected between the power line ($V_{DD}$) and the output terminal (305) of the anticipatory inverter.

6. A self-correcting frequency divider circuit wherein the circuit serves to convert an input n-bit counting stream into a 4n-bit counting stream and includes first and second cascaded frequency dividing circuits, the first circuit being a circuit as claimed in claim 4 and the second circuit being a circuit as claimed in claim 4 except that $n$ is twice as large in the second circuit as in the first circuit.

**Patentansprüche**

1. Selbstkorrigierende Frequenzteilerschaltung (50) zur Umwandlung eines n-Bit-Eingangszählstroms (I) mit einer Periode gleich nT in einen 2n-Bit-Ausgangszählstrom (Z) mit einer Periode gleich 2nT, wobei n eine ganze Zahl größer als Eins ist, jeder periodische Zählstrom eine Vielzahl von Zeitlagen gleich der Anzahl von Bits in jeder Periode besitzt, das durch eine der Zeitlagen in jeder Periode geführte Signal einen Binärpegel und das durch die oder jede weitere Zeitlage in jeder Periode geführte Signal den anderen Binärpegel hat, mit einem NOR-Gatter (51) mit zwei Eingängen, von denen ein Eingangsanschluß den n-Bit-Eingangszählstrom aufnimmt, und mit einer Verzögerungseinrichtung (52), deren Eingangsanschluß direkt mit dem Ausgangsanschluß des NOR-Gatters und deren Ausgangsanschluß direkt sowohl mit dem anderen Eingangsanschluß des NOR-Gatters als auch dem Ausgangsanschluß der Frequenzteilerschaltung verbunden ist, wodurch der Ausgangsanschluß der Frequenzteilerschaltung den 2n-Bit-Ausgangszählstrom abhängig von dem n-Bit-Eingangszählstrom liefert.

2. Schaltung nach Anspruch 1, bei der die Verzögerungseinrichtung (52) n in Reihe geschaltete Stufen besitzt, die je den Zählstrom um eine Zeitspanne gleich T verzögern.

3. Selbstkorrigierende Frequenzteilerschaltung, bie der die Schaltung zur Umwandlung eines n-Bit-Eingangszählstroms in einen 4n-Bit-Zählstrom dient und eine erste sowie eine zweite, in Reihe geschaltete Frequenzteilerschaltung aufweist, die erste Schaltung eine Schaltung nach Anspruch 1 oder 2 und die zweite Schaltung eine Schaltung nach Anspruch 1 oder 2 mit der Ausnahme ist, daß n bei der zweiten Schaltung doppelt so groß wie bei der ersten Schaltung ist.

4. Schaltung nach Anspruch 1, bei der die Verzögerungseinrichtung ein serielles Schieberegister mit n Stufen ist, der n-Bit-Zählstrom eine periodische Folge mit einem einzigen 1-Bit gefolgt von (n−1)-0-Bits ist, jedes Bit während einer getrennten Zeitlage der Dauer T gültig ist und jede Stufe des Registers so geschaltet ist, daß sie synchron mit den Zeitlagen getaktet wird.

5. Schaltung nach Anspruch 4, bei der der n-Bit-Zählstrom ein 3-Bit-Zählstrom ist, der von einem Zähler mit einer ersten (300, 203—205) und einer zweiten (206—209), in Reihe geschalteten dynamischen Master-Slave-Schieberegisterstufe erzeugt wird, ein Ausgangsanschluß der ersten und der zweiten Stufe mit einem ersten bzw. zweiten Eingangsanschluß eines weiteren NOR-Gatters (101) verbunden ist und der Ausgangsanschluß des NOR-Gatters an einen Eingangsanschluß eines vorhersehenden Inverters (300) angeschaltet ist, mit einem getakteten ersten Transistor (301), dessen Source-Drain-Strecke zwischen eine Stromversorgungsleitung ($V_{DD}$) und den Eingangsanschluß des vorhersehenden Inverters geschaltet ist, mit einem zweiten Transistor (302), dessen Gate-Anschluß mit dem Ausgangsanschluß des NOR-Gatters (101) und dessen Source-Anschluß mit einem Bezugsspannungsanschluß verbunden ist, mit einem dritten Transistor (303), dessen Source-Anschluß mit seinem Gate-Anschluß und dem Ausgangsanschluß (305) des vorhersehenden Inverters und dessen Drain-Anschluß mit der Stromversorgungsleitung ($V_{DD}$) verbunden ist, und mit einem vierten Transistor (304), dessen Gate-Anschluß mit dem Ausgangsanschluß der ersten Stufe verbunden ist und dessen Source-Drain-Strecke zwischen die Stromversorgungsleitung ($V_{DD}$) und den Ausgangsanschluß (305) des vorherstehenden Inverters geschaltet ist.

6. Selbstkorrigierende Frequenzteilerschaltung bei der die Schaltung zur Umwandlung n-Bit-Eingangszählstroms in einen 4n-Bit-Zählstrom dient und eine erste und eine zweite, in Reihe geschaltet Frequenzteilerschaltung aufweist, die erste Schaltung eine Schaltung nach Anspruch 4 und die zweite Schaltung eine Schaltung nach Anspruch 4 mit der Ausnahme ist, daß n bei der zweiten Schaltung doppelt so groß wie bei der ersten Schaltung ist.

**Revendications**

1. Un circuit diviseur de fréquence auto-correcteur (50) destiné à convertir un train de comptage d'entrée à n bits (I), ayant une périodicité égale à nT, en un train de comptage de sortie à 2n bits (Z) ayant une périodicité égale à 2T, en désignant par n un entier supérieur à l'unité, et dans lequel chaque train de comptage périodique comprend un ensemble d'intervalles de temps, en un nombre égal au nombre de bits dans une période quelconque, le signal acheminé par un seul des intervalles de temps dans chaque période ayant un niveau binaire, et le signal acheminé par l'autre intervalle de temps, ou chaque autre intervalle de temps, dans chaque période, ayant l'autre niveau, le circuit comprenant une porte NON-OU à deux entrées (51) dont l'une des deux bornes d'entrée est connectée de façon à recevoir le train de comptage d'entrée à n bits, et un dispositif de retard (52) dont la borne d'entrée est directement connectée à la borne de sortie de la porte NON-OU, et dont la borne de sortie est directement connectée à la fois à l'autre borne d'entrée de la porte NON-OU et à la borne de sortie du circuit diviseur de fréquence, grâce à quoi la borne de sortie du circuit fournit le train de comptage de sortie à 2n bits sous l'effet du train de comptage d'entrée à n bits.

2. Un circuit selon la revendication 1, dans lequel le dispositif de retard (52) comprend n étages connectés en série, chacun d'eux étant conçu de façon à retarder le train de comptage d'une durée égale à T.

3. Un circuit diviseur de fréquence auto-correcteur qui est utilisé pour convertir un train de comptage d'entrée à n bits en un train de comptage à 4n bits et qui comprend des premier et second circuits de division de fréquence connectés en cascade, le premier circuit étant un circuit selon la revendication 1 ou 2, et le second circuit étant un circuit selon la revendication 1 ou 2 à l'exception du fait qui n est deux fois plus élevé dans le second circuit que dans le premier circuit.

4. Un circuit selon la revendication 1, dans lequel le dispositif de retard est un registre à décalage série comportant n étages, le train de comptage à n bits consistant en une séquence périodique d'un seul bit "un" suivi par (n−1) bits "zéro", chaque bit étant valide pendant un intervalle de temps séparé de durée T, et chaque étage du registre est connecté de façon à recevoir un signal d'horloge en synchronisme avec les intervalles de temps.

5. Un circuit selon la revendication 4, dans lequel le train de comptage à n bits est un train de comptage à trois bits qui est produit par un compteur comportant des premier (300, 203—205) et second (206—209) étages de registre à décalage maître-esclave dynamiques connectés en série, une borne de sortie de chacun des premier et second étages étant respectivement connectées à des première et seconde bornes d'entrée d'une autre porte NON-OU (101), et la borne de sortie de la porte NON-OU étant connectée à une borne d'entrée d'un inverseur d'anticipation (300) qui comprend un premier transistor attaqué par des impulsions d'horloge (301) dont le circuit source-drain est connecté entre une ligne d'alimentation ($V_{DD}$) et la borne d'entrée de l'inverseur d'anticipation, un second transistor (302) dont la borne de grille est connectée à la borne de sortie de la porte NON-OU 101 et dont la borne de source est connectée à une borne de tension de référence, un troisième transistor (303) dont la borne de source est connectée à la borne de grille et à la borne de sortie (305) de l'inverseur d'anticipation, et dont la borne de drain est connectée à la ligne d'alimentation ($V_{DD}$), et un quatrième transistor (304) dont la borne de grille est connectée à la borne de sortie du premier étage, et dont le circuit source-drain est connecté entre la ligne d'alimentation ($V_{DD}$) et la borne de sortie (305) de l'inverseur d'anticipation.

6. Un circuit diviseur de fréquence auto-correcteur qui est utilisé pour convertir un train de comptage d'entrée à n bits en un train de comptage à 4n bits, et qui comprend des premier et second circuits de division de fréquence connectés en cascade, le premier circuit étant un circuit selon la revendication 4 et le second circuit étant un circuit selon la revendication 4 à l'exception du fait que $n$ est deux fois plus élevé dans le second circuit que dans le premier circuit.

# FIG. 1
(PRIOR ART)

# FIG. 2
(PRIOR ART

# FIG. 3
(PRIOR ART)

# FIG. 4
(PRIOR ART)

$$[\underbrace{1000 \text{---} 000}_{n}100 \text{---} 010 \text{--} 0] \cdot \div (n+1)$$

# FIG. 5

$$I = [\underbrace{0111 \text{---}}_{n} \underbrace{1110111 \text{---}}_{n} \underbrace{1110111 \text{---}}_{n-1} 1110 \text{---}] \cdot \div n$$

$$Z = [\underbrace{X00 \text{---} 00}_{n-1}\underbrace{X00 \text{---} 00}_{n-1}\underbrace{X00 \text{---} 00}_{n-1}\underbrace{X00 \text{---} 00}_{n-1}X0 \text{--}] \cdot \div 2n$$

$$X=1, \bar{X}=0, Z=[1000 \text{---} 000\underbrace{1000 \text{---}}_{2n} \underbrace{00010 \text{--}}_{2n}] \cdot \div 2n$$

$$X=0, \bar{X}=1, Z=[\underbrace{00 \text{--} 00}_{n}\underbrace{1000 \text{---} 000}_{2n}\underbrace{1000 \text{---} 0001 \text{--}}_{2n}] \cdot \div 2n$$

2

FIG. 6

FIG. 7

3

FIG. 8

FIG. 9